# EUROPÄISCHE PATENTANMELDUNG

(11) **EP 3 462 420 A1**
(43) Veröffentlichungstag der Anmeldung: **03.04.2019**
(21) Anmeldenummer: 18182808.8
(22) Anmeldetag: 11.07.2018
(51) Int. Cl.: G07C 9/00, H03K 17/95, H03K 17/97

(54) **FUNKSCHLÜSSEL FÜR KRAFTFAHRZEUGE**

(30) Priorität: 30.09.2017 DE 102017121823
(71) Anmelder: HUF Hülsbeck & Fürst GmbH & Co. KG, 42551 Velbert (DE)
(72) Erfinder: ZILLER, Boris, 40885 Ratingen (DE)
(74) Vertreter: Zenz Patentanwälte Partnerschaft mbB

(57) **Zusammenfassung**

Ein Funkschlüssel (1) für ein Fahrzeug, mit einer Kommunikations- und Steuereinrichtung (12) und wenigstens einer Sende/Empfangseinrichtung sowie einem Mikrocontroller.

An der Außenhülle eines Gehäuses (4) des Funkschlüssels ist wenigstens eine Bedienfläche (2a, 2b) angeordnet, welche zur Erfassung von Betätigungen mit der Kommunikations- und Steuereinrichtung gekoppelt ist. Eine Platine (10) ist in dem Gehäuse (4) aufgenommen und unterhalb der Bedienfläche (2a, 2b) platziert.

Die die Bedienfläche (2a, 2b) ist mit einem metallischen Detektionsabschnitt (3a, 3b) mechanisch gekoppelt, so dass eine Druckbetätigung der Bedienfläche von der Außenseite in einer Verformung oder Lageänderung des Detektionsabschnitts resultiert. Auf der Platine (10), unterhalb der Bedienfläche und des Detektionsabschnitts ist eine Detektionsspule (11a, 11b) ausgebildet, wobei die Detektionsspule mit der Kommunikations- und Steuereinrichtung zur Bildung eines induktiven Näherungsschalters gekoppelt ist. Die Kommunikations- und Steuereinrichtung ermittelt eine Betätigung der Bedienfläche in Abhängigkeit von der Induktivität oder Güte der Detektionsspule.

## Beschreibung

Die Erfindung betrifft einen Funkschlüssel für Kraftfahrzeuge. Funkschlüssel oder auch Funkfernbedienungen für Kraftfahrzeuge weisen eine Kommunikations- und Steuereinrichtung auf, welche wenigstens eine Sende-/Empfangseinrichtung und einen Mikrocontroller aufweisen. Ein Gehäuse bildet die Außenhülle des Funkschlüssels und an dem Gehäuse oder in dem Gehäuse sind ein oder mehrere Bedienflächen angeordnet, welche zur Erfassung von Betätigungen eines Benutzers vorgesehen sind. Dazu sind die Bedienflächen mit der Kommunikations- und Steuereinrichtung zur Erfassung einer Bedienung gekoppelt. Eine Platine ist in dem Gehäuse aufgenommen und unterhalb der Bedienfläche platziert, wobei wenigstens der Mikrocontroller auf dieser Platine angeordnet ist.

Funkschlüssel der eingangs genannten Art weisen regelmäßig Druckschalter oder Tastschalter auf.

Beispielsweise ist aus der DE 10 2013 105 195 A1 ein Fahrzeugschlüssel mit Tasten gezeigt. Dort ist eine Taste in einem Gehäuse beweglich zwischen Anschlägen gelagert und durchgreift einen Ausschnitt in dem Gehäuse.

Eine alternative Gestaltung eines Fahrzeugschlüssels ist beispielsweise aus der DE 10 2012 210 357 A1 bekannt. Dort ist eine hinterleuchtete Anzeige für einen Fahrzeugschlüssel dargestellt. Im Bereich des durchleuchteten Anzeigesymbols ist eine verringerte Wandstärke des Gehäuses vorgesehen.

Bei Funkschlüsseln der genannten Art sind mechanische Tasten vorgesehen, die aufwendig in der Produktion sind und eine teilweise unerwünschte Tastenhaptik aufweisen. Dies kann bedingt sein durch benötigte Schaltmatten oder Schaltmembranen oder Weichkomponenten oder auch weiche Tastenfelder, die zwar form- oder stoffschlüssig mit dem Gehäuse verbunden werden können, jedoch zu angrenzenden Gehäuseteilen unterschiedliche Haptik und Optik aufweisen.

Durch die Übergangsbereiche zwischen verschiedenen Materialien und sich gelegentlich bildende Spalte können Fremdstoffe, insbesondere Staub und Wasser ins Gehäuse eindringen, was sowohl die optische Anmutung als auch die Funktionsweise des Funkschlüssels beeinträchtigen kann. Außerdem sind die verwendeten Materialien häufig anfällig für Verschmutzungen und bei der Tastenbetätigung können unerwünschte Geräusche auftreten.

Aufgabe der Erfindung ist es, einen hinsichtlich der Fertigungskosten und Verschmutzungsanfälligkeit verbesserten Funkschlüssel mit optisch wertiger Gestaltung bereitzustellen.

Diese Aufgabe wird gelöst durch einen Funkschlüssel mit den Merkmalen des Patentanspruches 1.

Der erfindungsgemäße Funkschlüssel der eingangs genannten Art ist dadurch gekennzeichnet, dass eine Bedienfläche mit einem metallischen Detektionsabschnitt mechanisch gekoppelt ist, so dass eine Druckbetätigung der Bedienfläche von der Außenseite in einer Verformung oder Lageänderung des Detektionsabschnittes resultiert. Die Kopplung kann durch eine unmittelbare Verbindung, beispielsweise eine Beschichtung der Bedienfläche mit Metallen oder metallischen Lacken oder durch eine Ausgestaltung der Bedienfläche selbst mit einem metallischen Material vorgenommen sein. Außerdem kann eine mechanische Kopplung vorgesehen sein, beispielsweise eine Anlage eines auslenkbaren metallischen Detektionsabschnittes an der Innenseite der Bedienfläche in dem Gehäuse des Funkschlüssels.

Auf der Platine, also im Inneren des Gehäuses und unterhalb der Bedienfläche und des Detektionsabschnittes, ist eine Detektionsspule ausgebildet, wobei die Detektionsspule mit der Kommunikations- und Steuereinrichtung zur Bildung eines induktiven Näherungsschalters gekoppelt ist. Die Kommunikations- und Steuereinrichtung erfasst ein Maß für die Induktivität oder Güte der Detektionsspule und ermittelt eine Betätigung der Bedienfläche durch einen Benutzer in Abhängigkeit von dem Maß für die Induktivität oder Güte der Detektionsspule.

Induktive Näherungssensoren sind hinsichtlich ihres prinzipiellen Aufbaus bekannt. Beispielsweise gibt es Induktionsschalter im Handel käuflich zu erwerben, wobei die Produkte üblicherweise als Inductance-to-Digital Converters (LDC) vertrieben werden. Derartige Sensoren werden mit einer Spulenanordnung verbunden, die in der Nähe eines beweglichen, leitfähigen Bauteils angeordnet wird. Die Rolle des beweglichen Bauteils übernimmt in der Erfindung der metallische Detektionsabschnitt, welcher mit der Bedienfläche gekoppelt ist. Bezüglich der Anordnung eines solchen Sensors und der Ausbildung einer zugehörigen Spule wird beispielhaft auf die Anwendungshinweise von einschlägigen Chipherstellern verwiesen, beispielsweise den Texas Instruments Application Report SNOA930, März 2015, verfasst von Chris Oberhauser mit dem Titel "LDC Sensor Design".

Da induktive Sensoren Abstandsänderungen äußerst sensibel detektieren und außerdem gekapselt in dem Gehäuse des Funkschlüssels aufgenommen sind, genügt eine geringe Kraftbeaufschlagung der Bedienfläche, um den Detektionsabschnitt in seiner Lage zu verändern, was über die unterliegende Spule und eine damit gekoppelte Schaltung der Kommunikations- und Steuereinrichtung detektiert werden kann. Die Kommunikations- und Steuereinrichtung kann zu diesem Zweck einen LDC-Konverter aufweisen, alternativ kann eine Schaltung zur Auswertung der Induktivität oder Güte der Spule durch Einzelkomponenten aufgebaut sein.

Ändert sich die Lage bzw. der Abstand des Detektionsabschnittes gegenüber der Spule, ändert sich auch die Induktivität oder Güte der Spule. Diese Veränderung signalisiert eine Betätigung der Bedienfläche, welche von der Kommunikations- und Steuereinrichtung im Funkschlüssel erfasst wird. Beispielsweise kann dann eine zugeordnete Funktion, wie die Entriegelung oder Verriegelung eines Fahrzeuges über die Kommunikationskomponenten der Kommunikations- und Steuereinrichtung ausgelöst werden.

Ein Vorteil der Gestaltung eines Funkschlüssels mit einer induktiven Betätigungserfassung liegt in der Möglichkeit, auf mechanische Komponenten im Gehäuse verzichten zu können. Der induktive Sensor kann Verformungen, die im geringen Maße bei Druckbeaufschlagung eines Bereiches des Gehäuses resultieren, verlässlich erfassen. Die Oberfläche des Schlüssels kann auf diese Weise spaltfrei und homogen gestaltet werden, so dass Schmutz und Umwelteinflüsse nicht in den Schlüssel eindringen können. Es besteht daher ein erheblicher Vorteil darin, dass eine geschlossene Oberfläche im Bereich der Bedienfläche vorhanden ist, die fugenlos und ohne Materialunterbrechung oder auch ohne Gehäusedurchbrüche für Tasten oder andere Anzeigeelemente gestaltet ist. Es erhöht sich damit die mechanische Festigkeit und Gehäusesteifigkeit und die günstigere Herstellbarkeit durch einfachere Werkzeugnutzung wird begünstigt. Auch ist ein solcher Schlüssel optisch aufgewertet, da Flächen nicht mehr aufgrund ihrer mechanischen und dichtenden Eigenschaften mit nachteiliger Materialanmutung zu versehen sind.

Es ist bevorzugt, dass die Detektionsspule als spiralförmige Leiterbahn auf der Platine aufgedruckt ist.

Eine aufgedruckte Detektionsspule ist besonders einfach in der Fertigung und gegenüber den übrigen Komponenten auf der Platine leicht zu platzieren. Besonders bevorzugt ist es, eine kreisspiralen-förmige Spule zu verwenden, da diese hinsichtlich ihrer Erfassungsgenauigkeit für Abstandsänderungen hinsichtlich Güte und Widerstand optimal ist.

In einer bevorzugten Weiterbildung der Erfindung ist der Funkschlüssel mit einer Weckeinrichtung ausgebildet, die mit der Kommunikations- und Steuereinrichtung gekoppelt ist. Die Kommunikations- und Steuereinrichtung ist wiederum dazu ausgebildet, die Detektionsspule zu aktivieren und zu deaktivieren. Bei Deaktivierung der Detektionsspule ist eine Erfassung von Bedienungen nicht möglich. In Zeiten, in denen kein Benutzerzugriff zu erwarten ist, kann eine Fehlererfassung durch Deaktivierung der Detektionsspule ausgeschlossen werden. Außerdem ist eine Energieeinsparung durch Deaktivierung möglich. Die Kommunikations- und Steuereinrichtung ist gemäß dieser Ausführungsform so mit der Weckeinrichtung gekoppelt, dass die Detektionsspule in Abhängigkeit von einem Signal der Weckeinrichtung zeitweise aktiviert wird.

Die Bedienflächen, die mit der Detektionsspule überwacht werden, sind also nur zeitweise aktiviert, nämlich in Abhängigkeit von den Signalen der Weckeinrichtung. Beispielsweise kann dafür der Funkschlüssel einen extern zugänglichen Weckschalter aufweisen, der zunächst zu betätigen ist, bevor die induktiv überwachte Bedienfläche mit dem gekoppelten Detektionsabschnitt funktionsfähig ist. Eine solche Weckeinrichtung kann beispielsweise in Gestalt eines einzelnen Tastschalters am Schlüssel ausgebildet sein, alternativ können beispielsweise leitfähige Flächen zur Detektion am Schlüssel vorgesehen sein, die beim Umgreifen des Schlüssels mit der Haut eines Bedieners in Kontakt geraten und dann einen Weckimpuls liefern.

Vorzugsweise ist die Weckeinrichtung mit einem Bewegungssensor versehen, welcher Lageänderungen oder Beschleunigungen des Funkschlüssels erfasst und in Abhängigkeit davon ein Signal an die Kommunikations- und Steuereinrichtung ausgibt.

Ein solcher Bewegungssensor oder Lagesensor ist handelsüblich zu erhalten und häufig in mobilen Kommunikationsgeräten eingebaut. Die Kommunikations- und Steuereinrichtung kann nach dem Erhalt eines Wecksignals, ausgelöst durch eine Bewegung oder Lageänderung des Funkschlüssels, die Detektionsspule zur Überwachung der Bedienfläche mit den jeweiligen Detektionsabschnitten für eine vorgegebene Zeit, beispielsweise 30 Minuten oder 10 Minuten aktivieren. Befindet sich jedoch ein Funkschlüssel unbenutzt und unbewegt in einer Lagerposition, wird nach Ablauf einer Zeitspanne die Deaktivierung der Detektionsspule vorgenommen.

In einer alternativen Gestaltung ist die Weckeinrichtung mit einem kapazitiven Sensor ausgebildet, welcher eine Annäherung oder einen Zugriff eines Benutzers auf den Funkschlüssel erfasst und in Abhängigkeit davon ein Signal an die Kommunikations- und Steuereinrichtung ausgibt. Auch in dieser Gestaltung wird eine Aktivierung der Detektionsspule in Abhängigkeit von der Erfassung einer Benutzungshandlung vorgenommen. Ein kapazitiver Sensor kann jedoch auch berührungslose Annäherungen erfassen, es bedarf also nicht unbedingt einer Lageänderung oder Beschleunigung des Funkschlüssels, um die Detektionsspule zur Überwachung der Bedienfläche zu aktivieren.

In einer bevorzugten Gestaltung der Erfindung ist der Funkschlüssel im Bereich der Bedienfläche spaltfrei und integral mit dem umgebenden Gehäuse ausgebildet. Die Bedienfläche ist also in ihrer äußeren Deckseite spaltlos gegen das Eindringen von Schmutz und Flüssigkeiten geschützt und auch besonders einfach zu reinigen. Zur Innenseite des Gehäuses kann dabei das Gehäuse im Bereich der Bedienfläche durchaus unterschiedlich gestaltet sein, beispielsweise kann eine gezielte Schwächung des Gehäuses zur einfacheren Verformung der Bedienfläche durch äußeren Druck vorgesehen sein.

In einer bevorzugten Ausführungsform der Erfindung ist der Detektionsabschnitt durch metallische Beschichtung der Bedienfläche gebildet.

Eine solche metallische Beschichtung kann grundsätzlich im Außenbereich, also auf der Außenhülle des Gehäuses aufgebracht sein, jedoch auch im Innenbereich des Gehäuses, beispielsweise durch Aufbringen eines metallischen Lacks oder einer metallischen Folie unterhalb der Bedienfläche.

Die Erfindung wird nun anhand der beiliegenden Zeichnungen näher erläutert:
Figur 1 zeigt schematisch einen Funkschlüssel gemäß einer ersten Ausführungsform der Erfindung;
Figur 2 zeigt schematisch einen Schnitt durch den Funkschlüssel aus Figur 1;
Figur 3 zeigt schematisch wesentliche Komponenten auf der Platine, die in dem Funkschlüssel angeordnet ist.

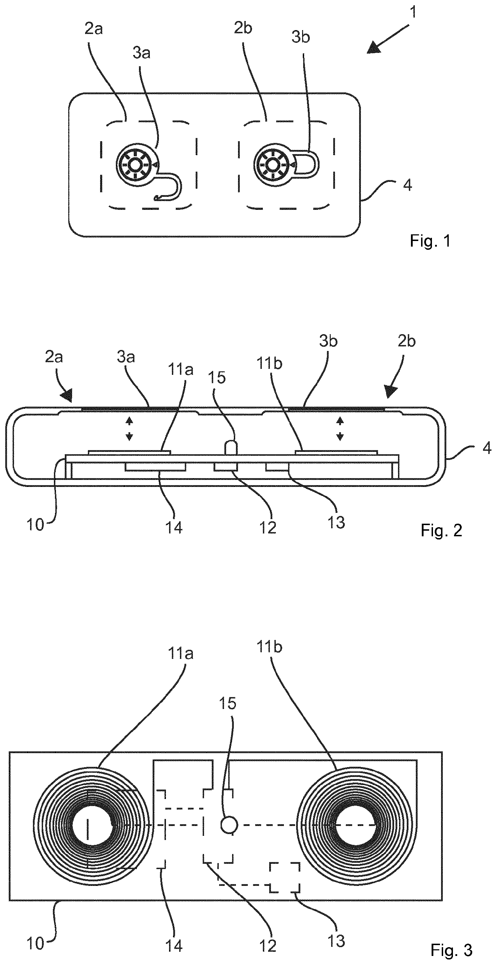

In Figur 1 ist ein Funkschlüssel 1 gezeigt, der zwei Bedienfelder 2a und 2b aufweist. In diesem Beispiel sind die Bedienfelder 2a und 2b mit Symbolen versehen, die mit den zugehörigen Funktionen zum Verschließen und Entriegeln eines Fahrzeuges verknüpft sind. Die in Figur 1 sichtbare Deckseite des Schlüssels ist aus einem transparenten Kunststoff gebildet, in welchen die Schlosssymbole 3a und 3b als metallische Einlagen eingebettet sind. Die Oberfläche des Funkschlüssels 1 im Bereich der Bedienfläche ist konturlos und spaltfrei ausgebildet, es ist eine nach außen durchgehende und glatte Oberfläche ausgebildet. Die mit durchbrochenen Linien gekennzeichneten Bereiche zeigen die Bedienflächen, die auf der Innenseite des Gehäuses mechanisch geschwächt sind, wobei die Gehäusewandung in diesen Bereichen dünner ausgebildet ist.

Figur 2 zeigt einen Schnitt in schematischer Ansicht durch den Funkschlüssel aus Figur 1. Das Gehäuse 4 ist in den Bedienbereichen 2a und 2b mit geringerer Wandstärke ausgebildet. Außerdem sind dort die metallischen Einlagen 3a und 3b im transparenten Gehäusematerial des Gehäuses 4 eingelassen und angeordnet. Unterhalb der Bedienflächen 2a, 2b und der darin eingelassenen metallischen Detektionsabschnitte 3a, 3b in Form von Bediensymbolen, liegt die Platine 10, die an der Rückseite des Gehäuses 4 befestigt ist. Auf der Platine 10 sind zwei Detektionsspulen 11a, 11b angeordnet, die in vertikaler Richtung unterhalb der Detektionsbereiche 2a, 2b und der metallischen Detektionsabschnitte 3a, 3b liegen. Die Detektionsspulen 11a, 11b sind mit der Kommunikations- und Steuerschaltung 12 über Leitungen auf der Platine verbunden. Ebenso ist ein Bewegungsschalter 13 auf der Rückseite der Platine angeordnet und mit der Kommunikations- und Steuerschaltung 12 gekoppelt, außerdem eine Energiezelle 14 in Form einer Batterie sowie eine LED 15 zum Hinterleuchten der transparenten Deckseite des Gehäuses 4.

In Figur 2 ist durch Pfeile angedeutet, dass eine Druckbetätigung der mechanisch geschwächten Bedienbereiche 2a oder 2b eine Lageänderung der metallischen Detektionsabschnitte 3a bzw. 3b zur Folge hat, welche die Induktivität der Spule 11a bzw. 11b oder deren Güte verändert. Dies wird durch eine entsprechende Schaltung in der Kommunikations- und Steuerschaltung 12 erfasst. Eine Aktivierung der Detektionsspulen 11a, 11b erfolgt über die Kommunikations- und Steuerschaltung 12 in Abhängigkeit von einem Signal des Bewegungssensors 13. Wird der Schlüssel 1 bewegt, wird eine Aktivierung sowohl der LED 15 als auch der Erfassung der Spuleninduktivitäten oder Spulengüte der Detektionsspulen 11a und 11b vorgenommen. Dann sind die transparenten Bereiche, welche die Detektionsabschnitte 3a, 3b im Bereich der Bedienflächen 2a, 2b umgeben durchleuchtet und dies signalisiert eine Bereitschaft, durch Druckbetätigung dieser Bereiche eine Betätigungserfassung durchzuführen.

Figur 3 zeigt eine Aufsicht auf die Platine 10 und die Anordnung der Detektionsspulen 11a und 11b auf der Platine. Auf derselben Seite der Platine 10 ist außerdem die LED 15 im Bereich zwischen den Detektionsspulen angeordnet, so dass sie beide Bedienbereiche 2a und 2b durchleuchten kann. Auf der Rückseite der Platine ist der Bewegungssensor 13 angeordnet, der mit der Kommunikations- und Steuerschaltung 12 gekoppelt ist. Eine Batteriezelle 14 versorgt die Kommunikations- und Steuerschaltung 12 mit Energie.

Es können noch weitere Komponenten vorgesehen sein, insbesondere Kommunikationskomponenten für eine hochfrequente Kommunikation außerhalb der Kommunikations- und Steuerschaltung 12, da diese für die Erfindung nicht wesentlich sind, sind sie jedoch in dieser Darstellung nicht gezeigt.

## Patentansprüche

1. Funkschlüssel (1) für ein Fahrzeug, mit einer Kommunikations- und Steuereinrichtung (12), welche wenigstens eine Sende/Empfangseinrichtung und einen Mikrocontroller aufweist,
mit einem Gehäuse (4), an dessen Außenhülle wenigstens eine Bedienfläche (2a, 2b) angeordnet ist, welche zur Erfassung von Betätigungen der Bedienfläche mit der Kommunikations- und Steuereinrichtung gekoppelt ist,
einer Platine (10), welche in dem Gehäuse (4) aufgenommen ist und unterhalb der Bedienfläche (2a, 2b) platziert ist und auf der wenigstens der Mikrocontroller platziert ist,
**dadurch gekennzeichnet,**
**dass** die Bedienfläche (2a, 2b) mit einem metallischen Detektionsabschnitt (3a, 3b) mechanisch gekoppelt ist, so dass eine Druckbetätigung der Bedienfläche von der Außenseite in einer Verformung oder Lageänderung des Detektionsabschnitts resultiert,
wobei auf der Platine (10), unterhalb der Bedienfläche und des Detektionsabschnitts eine Detektionsspule (11a, 11b) ausgebildet ist, wobei die Detektionsspule mit der Kommunikations- und Steuereinrichtung zur Bildung eines induktiven Näherungsschalters gekoppelt ist, wobei die Kommunikations- und Steuereinrichtung ein Mass für die Induktivität oder Güte der Detektionsspule ermittelt und eine Betätigung der Bedienfläche in Abhängigkeit von dem Mass für die Induktivität oder Güte der Detektionsspule erfasst.

2. Funkschlüssel gemäß Anspruch 1, wobei die Detektionsspule (11a, 11b) als spiralförmige Leiterbahn auf der Platine (10) aufgedruckt ist.

3. Funkschlüssel nach einem der Ansprüche 1 oder 2, wobei die Kommunikations- und Steuereinrichtung zur Aktivierung und Deaktivierung der Detektionsspule (11a, 11b) ausgebildet ist,
wobei eine Weckeinrichtung mit der Kommunikations- und Steuereinrichtung gekoppelt ist,
wobei die Kommunikations- und Steuereinrichtung die Detektionsspule in Abhängigkeit von einem Signal der Weckeinrichtung zeitweise aktiviert.

4. Funkschlüssel nach Anspruch 3, wobei die Weckeinrichtung einen Bewegungssensor (13) aufweist, welcher Lageänderungen oder Beschleunigungen des Funkschlüssels (1) erfasst und in Abhängigkeit davon ein Signal an die Kommunikations- und Steuereinrichtung (12) ausgibt.

5. Funkschlüssel nach Anspruch 3, wobei die Weckeinrichtung einen kapazitiven Sensor aufweist, welcher eine Annäherung oder einen Zugriff eines Benutzers gegenüber dem Funkschlüssels erfasst und in Abhängigkeit davon ein Signal an die Kommunikations- und Steuereinrichtung ausgibt.

6. Funkschlüssel nach einem der vorangehenden Ansprüche, wobei die Bedienfläche integral mit dem an die Bedienfläche angrenzenden Gehäuse spaltfrei ausgebildet ist.

7. Funkschlüssel nach einem der vorangehenden Ansprüche, wobei die Bedienfläche wenigstens teilweise transparent ausgebildet und wenigstens teilweise hinterleuchtet ist.

8. Funkschlüssel nach einem der vorangehenden Ansprüche, wobei der Detektionsabschnitt durch metallische Beschichtung der Bedienfläche gebildet ist.
